Europäisches Patentamt

European Patent Office

Office européen des brevets

(19)

(11) Veröffentlichungsnummer : **0 144 838**
**B1**

(12) **EUROPÄISCHE PATENTSCHRIFT**

(45) Veröffentlichungstag der Patentschrift :
11.10.89

(51) Int. Cl.⁴ : **H 01 J 37/34**

(21) Anmeldenummer : 84113852.2

(22) Anmeldetag : 16.11.84

(54) Magnetronkatode zum Zerstäuben ferromagnetischer Targets.

(30) Priorität : 05.12.83 DE 3343875

(43) Veröffentlichungstag der Anmeldung :
19.06.85 Patentblatt 85/25

(45) Bekanntmachung des Hinweises auf die Patenterteilung : 11.10.89 Patentblatt 89/41

(84) Benannte Vertragsstaaten :
AT BE CH DE FR GB IT LI LU NL SE

(56) Entgegenhaltungen :
US—A— 4 391 697
US—A— 4 414 086
4ème COLLOQUE INTERNATIONAL SUR LES PLAS-
MAS ET LA PULVERISATION CATHODIQUE, 13.-17.
September 1982, Seiten 243-246, Nice, FR; C. MORRI-
SON: "High rate sputtering of highly permeable
materials"

(73) Patentinhaber : LEYBOLD AKTIENGESELLSCHAFT
Wilhelm-Rohn-Strasse 25
D-6450 Hanau am Main (DE)

(72) Erfinder : Wirz, Peter, Dr.-Phys.
Klosterstrasse 5
D-6296 Waldernbach (DE)

(74) Vertreter : Zapfe, Hans, Dipl.-Ing.
Am Eichwald 7
D-6056 Heusenstamm 2 Rembrücken (DE)

## Beschreibung

Die Erfindung betrifft eine Magnetonkatode nach dem Oberbegriff des Patentanspruchs 1.

Magnetronkatoden mit ebenen oder gewölbten Zerstäubungsflächen sind hinreichend bekannt. Dabei wird eine räumlich definierte Anordnung von Permanent- und/oder Elektromagneten in einer solchen relativen Lage zur Zerstäubungsfläche vorgesehen, daß über der Zerstäubungsfläche ein ringförmig geschlossener Tunnel von Magnetfeldlinien erzeugt wird, durch den die den Zerstäubungsvorgang bewirkende Glimmentlagund auf einen Bereich in unmittelbarer Nähe der Zerstäubungsfläche begrenzt und dadurch die Zerstäubungsrate um mehr als eine Zehnerpotenz erhöht wird. Mit « Zerstäubungsfläche » wird die der Glimmentladung ausgesetzte, wirksame Targetoberfläche bezeichnet, von der die zerstäubten Partikel ausgehen, in der Regel also die Targetvorderfläche (DE-AS 24 31 832).

Derartige Magnetronkatoden sind in mehreren Varianten bekannt geworden, die entweder eine begrenzte Anwendungsmöglichkeit haben und/oder die in sie gesetzten Erwartungen nicht voll erfüllen. So werden bei der bekannten Ausführungsform die Polflächen des Magnetsystems hinter dem Target angeordnet, so daß die Mehrzahl der Magnetfeldlinien die Targetfläche zweimal durchdringt. Eine solche Bauweise ist jedoch für Targets aus magnetischen Werkstoffen, die z. B. für die Herstellung von magnetischen Aufzeichnungsbändern benötigt werden, entweder nicht oder nur in Verbindung mit zusätzlichen Maßnahmen brauchbar.

Diese Maßnahmen können beispielsweise darin bestehen, das Target sehr dünn auszubilden, so daß eine ausreichende Anzahl von Magnetfeldlinien das Target durchdringen kann. Eine solche Maßnahme setzt jedoch eine häufige Targeterneuerung voraus. Eine weitere Möglichkeit besteht darin, die Vorrichtung im magnetischen Sättigungsbereich des Targetmaterials zu betreiben, was jedoch außerordentlich starke Magnetsysteme voraussetzt, ohne daß es bisher gelungen wäre, die Verzerrungen des Magnetfeldes in den Griff zu bekommen, die sich mit zunehmendem Verbrauch des Targetmaterials ändern.

Weiterhin ist es möglich, das Targetmaterial auf eine Temperatur oberhalb des spezifischen Curie-Punktes zu erhitzen, so daß die magnetischen Feldlinien auch dickere Targetplatten durchdringen können. Die Curie-Temperaturen liegen je nach Targetmaterial zwischen etwa 400 und 1100 °C, so daß erhebliche thermische Probleme mit einer solchen Lösung verbunden sind. Es ist dabei auch bekannt, den Austritt der Feldlinien durch Nuten in der Targetfläche zu erleichtern (US-PS 4 299 678).

Durch die US-PS 4 198 283 ist eine Magnetronkatode bekannt, bei der das aus mehreren Teilstücken bestehende Target zwischen weichmagnetischen Polschuhen eingespannt ist. Durch die Art der Einspannung wird jeglicher Luftspalt vermieden und die Verwendung von Targets aus ferromagnetischen Werkstoffen ist ausgeschlossen, weil nämlich in einem solchen Fall die magnetischen Feldlinien aus den Polschuhen in Querrichtung in das Target eintreten würden, so daß es nicht mehr zur Ausbildung eines magnetischen Tunnels bzw. des Magnetroneffekts kommt.

Die US-A-4 391 697 offenbart eine Magnetronkatode, bei der der eine Magnetpol hinter dem aus magnetischen Werkstoff bestehenden zentralen Teil des Targets angeordnet ist. Dieser zentrale Teil ist unter Belassung eines einzigen Luftspalts von einem peripheren Targetteil umgeben, das in gewissen Umfange die Funktion von Polschuhen hat. Die Magnetfeldlinien können nur im Bereich des einen umlaufenden Luftspalts vom peripheren Targetteil in den zentralen Targetteil eintreten, wobei die maximale Zerstäubungswirkung ausgerechnet im Bereich des Luftspalts auftritt, der zu diesem Zweck breiter sein muß als der unter Betriebsbedingungen erforderliche Dunkelraumabstand, also mindestens 3 mm breit sein muß. In der Umgebung des Luftspalts befindet sich nun aber verhältnismäßig wenig Zerstäubungsmaterial und der Luftspalt wird durch den Zerstäubungsprozeß sogar noch verbreitert. Es muß daher durch besondere Maßnahmen dafür Sorge getragen werden, daß nicht vom Boden des Luftspalts Material zerstäubt wird, das im Falle eines nicht-kompatiblen Werkstoffs die niedergeschlagenen Schichten verunreinigen würde. Mit einer derartigen Lösung kann im wesentlichen nur Material in unmittelbarer Nachbarschaft des Luftspalts zerstäubt werden, so daß der Materialausnutzungsgrad sehr gering ist. Die für eine flächige Abtragung des Targetmaterials schädliche, im Bereich des einzigen Luftspalts örtlich hohe Magnetfeldkonzentration wird durch unmittelbare Ankopplung der Targetteile an die Magnetpole über hochpermeable Bauteile sogar noch verstärkt.

Durch die DE-OS 32 44 691 ist eine Magnetronkatode der eingangs beschriebenen Gattung mit zwei Luftspalten bekannt, bei der die Permanentmagnete vor einer Ebene angeordnet sind, die durch die Zerstäubungsfläche des Targets gebildet wird. Dadurch befinden sich die Permanentmagnete in einer Zone höchster thermischer Belastung, so daß die beschriebene Anordnung äußerst wirksam zu kühlen ist. Da die Permanentmagnete im Hinblick auf die vorgeschriebene Magnetisierungsrichtung eine bestimmte axiale Länge von etwa 8 bis 10 mm nicht unterschreiten können, sind die Polschuhe zur Begrenzung der Luftspalt-Breite an ihren Innenkanten mit kragenförmigen Fortsätzen versehen. Die an den Kragenrändern austretenden Feldlinien werden auf einem sehr kurzen Weg in das Targetmaterial gelenkt, aus dem sie, dem Weg des geringsten Widerstandes folgend, wieder in die Gegenpole der Permanentmagnete eintreten, da das ferromagnetische Target, die ferromagnetische Stützplatte und die Permanentmagnete direkt aufeinander sitzen. Die Folge ist eine enge Begrenzung der « magnetischen Falle », so daß anstelle einer an sich wünschenswerten flächigen Abtragung des Targetmaterials zwei grabenförmige Erosionszonen unterhalb der Kragenränder die Folge sind. Durch die Anordnung der Kragen verteuert sich der Herstellprozeß wesentlich, was insofern von Nachteil ist, als die Polschuhe selbst am Zerstäubungsprozeß teilnehmen, so daß nur eine geringe Standzeit die Folge ist.

Der Erfindung liegt daher die Aufgabe zugrunde, eine Magnetronkatode der eingangs beschriebenen Gattung dahingehend zu verbessern, daß mit ihr ferromagnetische Targetwerkstoffe wirtschaftlich, d. h. bei Langzeitbetrieb, mit hoher spezifischer Zerstäubungsleistung und bei hoher Materialausnutzung zerstäubt werden können, ohne daß es hierfür eines komplizierten Katodenaufbaus bedarf.

Die Lösung der gestellten Aufgabe erfolgt bei einer Magnetronkatode nach dem Oberbegriff des Anspruchs 1 erfindungsgemäß durch das im Kennzeichen des Anspruchs 1 enthaltene Merkmal.

Die Breite « s » des Luftspalts kann dabei zwischen 0,5 und 2,5 mm betragen. Auf die angegebene Weise wird ein über einen geringen Bereich von planparallelen Wänden begrenzter Luftspalt gebildet, der so eng ist, daß sich in diesem Spalt keine Glimmentladung ausbilden kann, die an dieser Stelle eine Zerstäubung bewirken könnte.

Hierdurch wird gegenüber der US-A-4 391 697 erreicht, daß der Zerstäubungsvorgang ausschließlich außerhalb des Luftspaltes bzw. der Luftspalte stattfindet. Weder kann also gegebenenfalls verunreinigendes Material aus dem Grund der Luftspalte zerstäubt werden, noch nimmt die Breite der Luftspalte bei Langzeitbetrieb zu, d. h. die für eine hohe Reproduzierbarkeit notwendige konstante Feldlinienverteilung bleibt erhalten. Die Materialabtragung erfolgt dabei über eine größere Fläche verteilt, so daß auch der sogenannte Ausnutzungsgrad des Materials merklich erhöht wird.

Der vorstehend beschriebene Effekt ist beim Betrieb der Magnetronkatode auch deutlich zu erkennen : Oberhalb der Zerstäubungsfläche bildet sich im Bereich neben dem Luftspalt je nach der Zahl der Luftspalte je ein intensiver Plasmaschlauch aus, der dem Verlauf des Luftspalts folgt. Im Bereich dieser Plasmaschläuche die sich über einen beträchtlichen Teil der Oberfläche des Targets erstrecken, herrscht ein hoher Ionisationsgrad durch Sekundärelektronen.

Durch die erfindungsgemäße Magnetronkatode lassen sich auch dicke planparallele Targetplatten zerstäuben. Diese Möglichkeit ist insbesondere deswegen gegeben, weil eine magnetische Sättigung des Targetmaterials nicht erforderlich ist. Damit verbunden ist eine große Standzeit der Magnetronkatode bis zum Targetwechsel, so daß auch ein wirtschaftlicher Einsatz der gesamten Anlage möglich ist. Bekanntlich bedingt eine solche Anlage einen hohen Kapitaleinsatz.

Es ist dabei gemäß der weiteren Erfindung besonders vorteilhaft, wenn sich die Projektionen der Targetteile in eine zur Zerstäubungsfläche parallele Ebene im wesentlichen in einem gleichbleibend breitem Bereich unter Einschluß des mindestens einen Luftspalts um ein Maß « d » überlappen. Dieses Maß der Überlappung kann dabei je nach Targetdicke zwischen 2 und 10 mm liegen.

Eine besonders vorteilhafte Ausführungsform des Erfindungsgegenstandes ist gemäß der weiteren Erfindung dadurch gekennzeichnet, daß bei einem dreiteiligen Target

a) eine Targetplatte durch einen umlaufenden Spalt in zwei zwischen gemeinsamen Ebenen liegende Targetteile unterteil ist, wobei der Spaltverlauf dem Verlauf des Zwischenraums zwischen den entgegengesetzten Polen geometrisch ähnlich ist,

b) der Spalt durch den Vorsprung aus dem nicht-ferromagnetischen, aber elektrisch leitfähigen Werkstoff ausgefüllt ist, der über die Zerstäubungsflächen der Targetteile vorspringt,

c) ein drittes Targetteil auf den Vorsprung aufgesetzt und ringförmig geschlossen ausgebildet ist und sein Verlauf dem Verlauf des Vorsprungs folgt, und daß

d) das dritte Targetteil beiderseits über den Vorsprung übersteht und gegenüber den Targetteilen je einen Luftspalt bildet.

Durch die vorstehend beschriebene Maßnahme wird eine Verdoppelung des Effekts erreicht und damit ein noch wesentlich gesteigerter Ausnutzungsgrad des Targetmaterials bzw. eine höhere Zerstäubungsleistung des gesamten Magnetrons. Damit können entweder in kürzerer Zeit gleich größere Schichtdicken oder größere Schichtdicken in der gleichen Zeit erzeugt werden. Dies ist besonders vorteilhaft, wenn großflächige Substrate relativ zur Magnetronkatode bewegt werden. Hierbei können entweder bei gleicher Bewegungsgeschwindigkeit größere Schichtdicken oder bei gleicher Schichtdicke größere Bewegungsgeschwindigkeiten und damit größere Durchsätze durch eine mit der Magnetronkatode bestückte Anlage erzielt werden.

Ausführungsbeispiele des Erfindungsgegenstandes werden nachfolgend anhand der Figuren 1 bis 7 näher erläutert.

Es zeigen :

Figur 1 einen Axialschnitt durch eine rotationssymmetrische Magnetronkatode mit einem ringförmig geschlossenen Luftspalt,

Figur 2 einen Axialschnitt analog Figur 1, jedoch bei einer Magnetronkatode, mit zwei ringförmig geschlossenen Luftspalten,

Figuren 3 und 4 Draufsichten auf verschiedene Formen des Magnetrons und ihre Variationsmöglichkeiten,

Figuren 5 bis 7 einen Axialschnitt durch den Gegenstand von Figur 2 unter Weglassung der nicht den Feldverlauf beeinflussenden Bauteile sowie die mit der Anordnung nach Figur 5 verbundenen Flußdiagramme, und zwar als Horizontalkomponente (Figur 6) und als Vertikalkomponente (Figur 7).

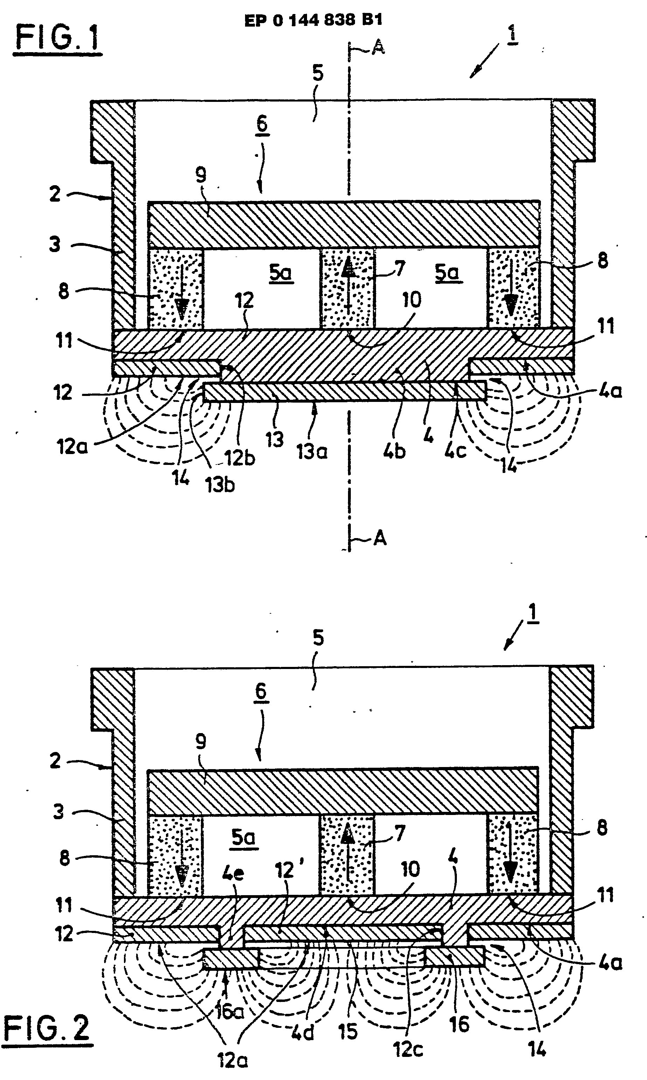

In Figur 1 ist eine Magnetronkatode 1 gezeigt, die einen topfförmigen Hohlkörper 2 aufweist, der aus einer Zarge 3 und einem Boden 4 besteht, die beide einen etwa zylindrischen Hohlraum 5 umschliessen. Der Hohlkörper 2 ist an einer nicht gezeigten Tragplatte befestigt, über die die Magnetronkatode ihrerseits mit einer gleichfalls nicht gezeigten Vakuumkammer verbunden ist. Einzelheiten einer solchen Anordnung können der DE-OS 30 47 113 entnommen werden.

Im Hohlraum 5 befindet sich ein Magnetsystem 6, das aus zahlreichen Permanentmagneten 7 und 8 besteht. Bei dem Permanentmagneten 7 handelt es sich um einen zylindrischen Magneten, während eine geschlossene, kreisförmige Reihe von Permanentmagneten 8 den zentralen Permanentmagneten 7 mit Abstand umgibt. Dabei haben die Permanentmagnete eine durch die eingezeichneten Pfeile definierte Pollage, d. h. bei dem mittleren Permanentmagneten 7 liegt beispeilsweise der Nordpol oben, während bei den äußeren Permanentmagneten 8 sämtliche Südpole oben liegen. Die Magnetpole sind durch einen kreisringförmig geschlossenen Zwischenraum 5a getrennt, der den Permanentmagneten 7 umgibt.

Sämtliche Permanentmagnete stehen mit ihren oberen Polflächen mit einer ferromagnetischen Jochplatte 9 in Berührung, während die entgegengesetzten Polflächen 10 bzw. 11 auf dem Boden 4 aufliegen. Dieser Boden besitzt eine Auflagefläche 4a, die als Kreisringfläche ausgebildet ist, und mit der unter flächiger Auflage ein kongruentes, kreisringförmiges Targetteil 12 verbundenist, beispielsweise durch flächiges Auflöten. Das Targetteil 12 besitzt eine gleichfalls kreisringförmige Zerstäubungsfläche 12a, sowie eine Durchbrechung 12b, die durch Heraustrennen eines zylindrischen Teils entstanden ist. In diese Durchbrechung ragt ein Vorsprung 4b hinein, der Teil des Bodens 4 sein kann, aber auch durch Auflöten eines entsprechend geformten Zylinderstücks gebildet werden kann. Dieser Vorsprung ist elektrisch leitfähig, und besteht im allgemeinen aus Kupfer, da auch die Zarge 3 und der Boden 4 in der Regel aus Kupfer hergestellt werden.

Der Vorsprung 4b ragt bis über die Zerstäubungsfläche 12a hinaus und trägt ein Targetteil 13, das ebenso wie das Targetteil 12 aus einem ferromagnetischen Werkstoff besteht. Vorsprung 4b und Targetteil 13 berühren sich flächig in einer ebenen Auflagefläche 4c. Das Targetteil 13 besitzt eine Außenfläche 13a, die aus identischem ferromagnetischen Material besteht; bevorzugt besteht aber das gesamte Targetteil 13 homogen aus ferromagnetischem Material.

Zwischen den Targetteilen 12 und 13 ist auf deren Umfang in Tiefenrichtung der Katode (parallel zur Achse A-A) ein kreisringförmiger Luftspalt 14 vorhanden, der aufgrund der weiter unten noch näher beschriebenen Überlappung von planparallelen Wänden begrenzt ist, und eine Breite zwischen 0,5 mm und 2,5 mm hat und — in der Projektion — innerhalb des Zwischenraums 5a liegt.

Die Überlappung ergibt sich dadurch, daß sich die Projektionen der Targetteile 12 und 13 in eine zur Zerstäubungsfläche 12a parallele Ebene überlappen, und zwar ist die Überlappung auf dem gesamten Umfang gleich breit. In dem Luftspalt brennt keine Glimmentladung, so daß an dieser Stelle auch keine Zerstäubung stattfindet.

Das Targetteil 13 besitzt eine seitliche Begrenzungsfläche 13b, die im vorliegenden Falle eine Zylinderfläche ist, und deren Erzeugende infolgedessen senkrecht zur Zerstäubungsfläche 12a verläuft.

Die seitliche Begrenzungsfläche 13b ist gleichzeitig die Austrittsfläche bzw. Polfläche, aus der ein großer Teil der magnetischen Feldlinien in Richtung auf das Targetteil 12 austritt. Ein Teil der Feldlinien tritt allerdings auch — mit abnehmender Tendenz zur Mitte hin — aus der Außenfläche 13a aus. Die Feldlinien haben im wesentlichen den in Figur 1 dargestellten Verlauf, wobei aufgrund der unterschiedlichen radialen Lage der Kulminationspunkte der Feldlinien zueinander auf einen entsprechend breiten Erosionsgraben geschlossen werden kann, der nach längerer Zerstäubungsdauer in dem Targetteil 12 entsteht. Der gezeigte Feldlinienverlauf ist nur möglich, weil die Targetteile 12 und 13 den Luftspalt 14 zwischen sich einschliessen, der einen magnetischen Kurzschluß verhindert und den Fluß zwingt, in der gezeigten Weise aus- bzw. einzutreten. Der Verlauf des Luftspalts 14 ist zum Verlauf des Zwischenraums geometrisch ähnlich, und, wie aus Figur 1 ersichtlich, sind die Auflageflächen 4a und 4c und damit die Targetteile 12 und 13 in Tiefenrichtung gestaffelt angeordnet.

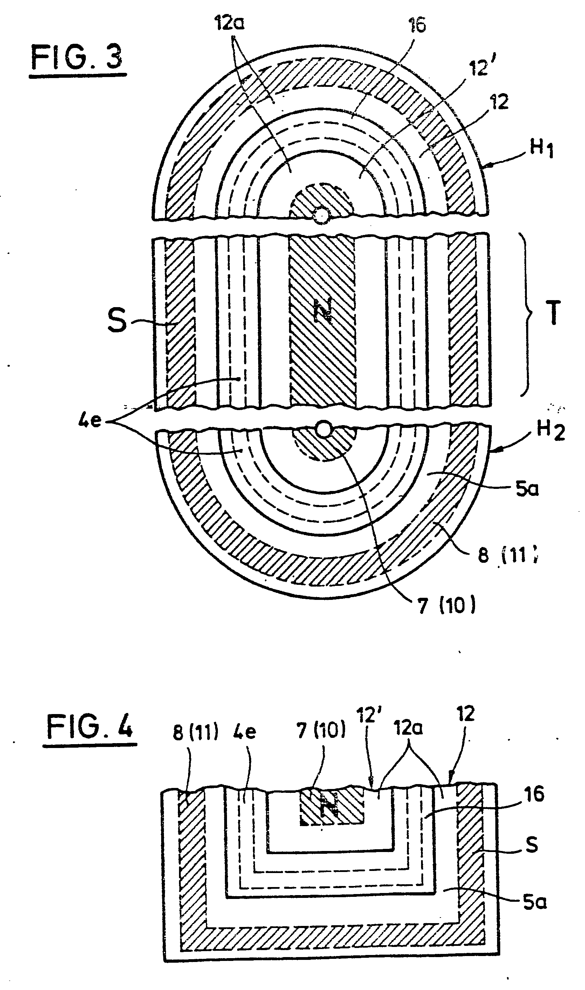

Wie bereits ausgeführt wurde, zeigt die Figur 1 einen Axialschnitt durch eine rotationssymmetrische Magnetronkatode. Es wird anhand der Figuren 3 und 4 jedoch noch aufgezeigt werden, daß die Erfindung nicht auf ein rotationssymmetrisches System beschränkt ist, sondern auch bei sogenannten ovalen oder Rechteckkatoden angewandt werden kann. Zur Vereinfachung der Beschreibung werden jedoch auch die nachfolgenden Erläuterungen anhand eines rotationssymmetrischen Systems gegeben.

In Figur 2 sind gleiche Teile wie in Figur 1 mit gleichen Bezugszeichen versehen. Eine andere Ausbildung haben hier im wesentlichen nur der Boden 4, die Targetteile 12, 12' und 13.

Im vorliegenden Fall ist das Target durch einen umlaufenden Spalt 12c unterbrochen, der eine Breite von einigen mm hat und durch den zusätzlich zum kreisring förmigen Targetteil 12 ein dazu konzentrisches kreisringförmiges Targetteil 12' gebildet wird. An dessen Ort besitzt der Boden 4 eine zusätzliche Auflagefläche 4d, die mit der Auflagefläche 4a in einer gemeinsamen Ebene liegt. Bei gleicher Dicke der Targetteile 12 und 12' liegen dabei auch deren beiderseitigen Begrenzungsflächen in gemeinsamen Ebenen.

Der Spalt 12c hat dabei einen geometrisch ähnlichen Verlauf wie der Zwischenraum 5a, d. h. beide verlaufen koaxial, wobei der mittlere Durchmesser des Spaltes 12c gegenüber dem mittleren Durchmesser des Zwischenraums 5a um ein gewisses Maß abweichen kann. Der Boden 4 besitzt einen zu dem Spalt 12c im wesentlichen komplementären, nämlich ringförmigen Vorsprung 4e, der über die Zerstäubungsfläche 12a, die sich auf beide Targetteile 12 und 12' verteilt, hinaus erstreckt. Der Vorsprung kann auch hier in analoger Weise wie bei Figur 1 durch Auflöten eines kurzen Hohlzylinders hergestellt werden. Der Vorsprung 4e besitzt eine nicht näher bezeichnete Kreisringfläche, auf der ein kreisringförmiges Targetteil 16 befestigt ist, das aus dem gleichen Werkstoff besteht wie die Targetteile 12 bzw. 12'. Das Targetteil 16 ragt beiderseits um ein etwa gleiches Maß über den Vorsprung 4e hinaus. Dadurch sowie durch die relativ zur Zerstäubungsfläche 12a größere axiale Erstreckung des Vorsprungs 4e wird beiderseits des Vorsprungs 4e je ein von planparallelen Wänden begrenzter Luftspalt 14 bzw. 15 erzeugt.

Beide Luftspalte 14 und 15 haben dabei eine analoge Ausbildung und Funktion wie der in Figur 1 nur einfach vorhandene Luftspalt 14. Es besteht lediglich der Unterschied, daß der Luftspalt 15 radial einwärts gerichtet ist, so daß nunmehr auch die Zerstäubungsfläche 12a des innenliegenden Targetteils 12' als Eintrittsfläche dür den magnetischen Fluß dient, der überwiegend im Bereich der inneren zylindrischen Begrenzungsfläche des Targetteils 16 aus diesem austritt.

Der prinzipielle Verlauf der Magnetfeldlinien ist in Figur 2 gleichfalls angedeutet, und es ist ersichtlich, daß im Innenraum des Targetteils 16 eine weitere Plasmafalle bzw. ein weiterer Magnetroneffekt ausgebildet wird, so daß sich der Vorgang im Prinzip verdoppelt. Damit wird die Leistungsfähigkeit, bezogen auf die gesamte Unterseite der Magnetronkatode wesentlich vergrößert, und zwar je nach der geometrischen Form der Katode (Figuren 3 und 4) bis auf den doppelten Wert.

Es ist zu erkennen, daß auch hier der Verlauf des aufgesetzten Targetteils 16 dem Verlauf des Vorsprungs 4e folgt, so daß die der Überlappung entsprechende Tiefe der Luftspalte 14 bzw. 16 jauf dem gesamten Umfang konstant ist.

In Weiterbildung des Gegenstandes nach Figur 2 kann das Target unter mehrfacher Wiederholung dieses Prinzips auch mehrfach unterbrochen sein, wodurch sich sowohl die Zerstäubungsleistung als auch der Ausnutzungsgrad des Targetmaterials weiter steigern lassen.

In Figur 3 sind — in der Draufsicht auf die Zerstäubungsfläche 12 a — Ausschnitte aus Magnetronkatoden mit verschiedenen geometrischen Formen dargestellt. Oben und unten ist jeweils die Hälfte $H_1$ und $H_2$ der Magnetronkatode nach Figur 2 dargestellt, d. h. die Vereinigung der beiden Hälften $H_1$ und $H_2$ führt zu einem rotationssymmetrischen Magnetron nach Figur 2. Setzt man zwischen die beiden Hälften $H_1$ und $H_2$ ein geradliniges Teil T ein, bei dem sämtliche Zerstäubungsflächen, Seitenflächen, Austrittsflächen und Luftspalte stufenlos in die entsprechenden Teile der rotationssymmetrischen Hälften einmünden, so ergibt sich eine langgestreckte Magnetronkatode nahezu beliebiger Längenabmessungen. Derartige Magnetronkatoden lassen sich mit Längen von etwa 4 m bei Breiten von etwa 0,2 bis 0,5 m herstellen, so daß mit ihnen unter Ausführung einer Relativbewegung auch die Beschichtung von großflächigen Substraten wie beispielsweise Architekturglas möglich ist. Die geometrische Ausbildung und Anordnung der Permanentmagnete 7 und 8 sowie deren Polflächen 10 und 11 ist durch gestrichelte Linien und Schraffuren angedeutet. Desgleichen sind durch gestrichelte Linien auch die Umlaufkanten des Vorsprungs 4e angedeutet, auf dem das Targetteil 16 befestigt ist. Der Querschnitt gemäß Figur 2 läßt sich auch auf den Querschnitt des geradlinigen Teils T übertragen. Der Verlauf des durch die Magnetfelder eingefangenen Plasmas entspricht dabei dem Verlauf des Targetteils 16, so daß für die geschlossenen Bereiche, in denen sich das Plasma ausbildet, auch der Begriff « Rennbahn » verwendet wird.

Es ist jedoch nicht erforderlich, die Enden einer langgestreckten Magnetronkatode analog Figur 3 rotationssymmetrisch auszubilden, sondern man kann diese Enden auch rechteckig gestalten, wie dies in Figur 4 dargestellt ist.

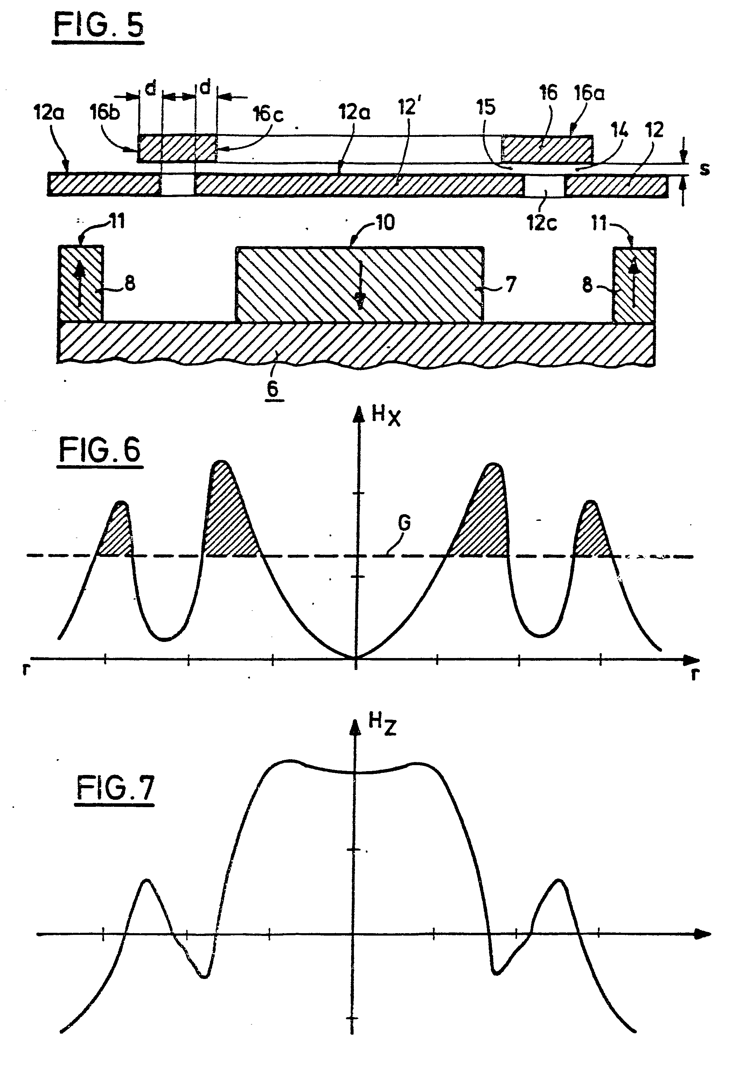

In Figur 5 sind unter Verwendung gleicher Bezugszeichen nur diejenigen Teile dargestellt, die einen maßgeblichen Einfluß auf den Verlauf des magnetischen Flusses haben. Es handelt sich um das Magnetsystem 6 mit den Permanentmagneten 7 und 8 sowie den Targetteilen 12 bzw. 12' und 16 jeweils unter Weglassung des diese Teile im Abstand zueinander haltenden Bodens 4 des Hohlkörpers 2. Die Anordnung ist gegenüber Figur 2 in Überkopflage dargestellt, da die Messungen der Magnetfelder, deren Ergebnis in den Figuren 6 und 7 dargestellt ist, in dieser Lage durchgeführt wurden.

In Figur 5 sind die beiderseitigen Überlappungen « d » des Targetteils 16 gegenüber den Targetteilen 12 und 12' als gleich groß dargestellt. Die Überlappungszonen können aber auch zum Zwecke einer Beeinflussung der Spalttiefe und damit der Verteilung des magnetischen Flusses unterschiedlich breit gestaltet werden, wobei lediglich darauf zu achten ist, daß das Maß der Überlappung « d » mindestens so groß ist, wie die Dicke des Targetteils 16, da bis zur Erschöpfung des Targetmaterials das Material im Bereich der Überlappung praktisch aufgebraucht bzw. zerstäubt wird. Die Dicke des Targetteils 16 sollte wegen der Standzeit des Targets mindestens 0,5 mm betragen, vorzugsweise aber der Dicke der Targetteile 12 bzw. 12' entsprechen, die ohne weiteres 10 bis 15 mm betragen kann.

Aus Gründen der Herstellung des Targetteils 16 verlaufen dessen Seitenflächen 16b und 16c zumindest anfänglich senkrecht zur Zerstäubungsfläche 12a, d.h. diese Flächen sind bei einem roationssymmetrischen Katodensystem Zylinderflächen. Es ist aber auch möglich, diese Flächen als Kegelflächen auszubilden, wobei der Querschnitt des Targetteils 16 mit zunehmender Entfernung von der Zerstäubungsfläche abnimmt. In analoger Weise ist es wiederum auch möglich, die äußeren Umlaufkanten des Targetteils 16 gut abzurunden.

Weiterhin ist Figur 5 auch das Maß « s » für die Spaltbreite der Luftspalte zu entnehmen, Diese Spaltbreite wird zwischen 0,5 und 2,5 mm gewählt. Einerseits darf der Spalt nicht zu eng sein, so daß er sich durch ferromagnetisches Material zusetzen könnte, andererseits darf er auch nicht zu groß sein, so daß sich die Glimmentladung in den Spalt hinein erstrecken könnte.

Die Verhältnisse gemäß Figur 5 sind maßstäblich (2 : 1). Zu Meßzwecken bestanden die Targetteile 12, 12' und 16 aus 3 mm dicken Eisenblech. Das Magnetsystem 6 entsprach demjenigen einer handelsüblichen Magnetronkatode der Firma Leybold-Heraeus GmbH in Hanau/Bundesrepublik Deutschland, wie sie unter der Typenbezeichnung PK 75 (75 mm Durchmesser) vertrieben wird. Die Spaltbreite « s » betrug 1 mm, da die Höhe des Vorsprungs 4e (Figur 2) 4 mm betrug. Das Maß « d » für die Oberlappung betrug auf beiden Seiten des Targetteils 16 4 mm.

An einer solchen Magnetronkatode wurde zunächst die horizontale Komponente der magnetischen Feldstärke ($H_x$) gemessen und über dem Radius « r » des Targets aufgetragen. Auch die Abszissenwerte der Figuren 6 und 7 entsprechen maßstäblich der Figur 5. In Figur 6 ist eine horizontale gestrichelte Grenzline « G » eingetragen. Die Lage dieser Grenzlinie bestimmt diejenige Feldstärke, oberhalb welcher ein merklicher Zerstäubungseffekt stattfindet. In dem Bereich der schraffierten Kurvenflächen findet also eine Abstäubung des Targetmaterials statt, d. h. es ist zu erkennen, daß durch ein einziges Magnetsystem jeweils zwei verhältnismäßig breite Zerstäubungszonen erzielt werden, die den Ausnutzungsgrad des Targetmaterials wesentlich vergrößern. Gemessen wurden Ausnutzungsgrade zwischen etwa 40 und 50 %.

In Figur 7 ist mit gleichem Maßstab wie in Figur 6 die vertikale Komponente der magnetischen Feldstärkeverteilung aufgetragen. Bezüglich dieser Kurve sind die Nulldurchgänge von Interesse. Auf jeder Seite existieren drei Nulldurchgänge, die theoretisch auf drei Erosionsgräber schliessen lassen. Aus Figur 6 ergibt sich jedoch, daß bei dieser Anordnung der Bauch zwischen den beiderseits der Ordinate liegenden Maxima so tief ist, daß eine ausreichende Zerstäubungsrate an der Stelle der mittleren Nulldurchgänge nicht zu erwarten ist. Durch Anpassung der Dicke des Targetteils 16 ist es somit möglich, dieses durch Schrauben zu befestigen, die auf dem mittleren Radius liegen, ohne daß diese Schrauben zerstäubt werden. Durch Änderung des Magnetfeldes ist es aber auch möglich, alle drei Erosionsgräben zu nutzen. In diesem Fall wird die Schraubenbefestigung durch ein Auflöten oder Bonden des betreffenden Targetteils ersetzt.

Der Dunkelraumabstand ist eine die Konstruktion von Zerstäubungskatoden bestimmende Größe. Die den Zerstäubungsvorgang bewirkende Glimmentladung ist aus Gründen der Ionisationswahrscheinlichkeit nur in einem ganz bestimmten Druckbereich beständig, der größenordnungsmäßig zwischen $2 \times 10^{-2}$ und $5 \times 10^{-4}$ mbar liegt. Die sich hierbei einstellenden druckabhängigen Dunkelraumabstände liegen oberhalb von 0,5 mm, aber unterhalb von etwa 2,0 bis 2,5 mm, d. h. die Spaltbreite « s » muß in dem angegebenen Bereich von 0,5 bis maximal 2,5 mm liegen, wenn mit Sicherheit verhindert werden soll, daß sich in dem entsprechend dimensionierten Spalt eine Glimmentladung ausbildet. Eine Spaltbreite « s » von 1,5 mm hat sich für den obigen Standarddruckbereich auch im Hinblick auf Fertigungstoleranzen für den Betrieb als optimal erwiesen.

## Patentansprüche

1. Magnetronkatode (1) zum Zerstäuben von Targets (12, 12') aus ferromagnetischen Materialien, bestehend aus einem Katodengrundkörper mit mindestens einer Auflagefläche (4a, 4c, 4d) für das Target, mit einem Magnetsystem (6) mit einem Joch (9) und auf diesem angeordneten, jeweils entlang einer geschlossenen Umfangslinie eine Poleinheit bildenden Magnetpolen entgegengesetzter Polarität, wobei die Projektion in eine gemeinsame Ebene der inneren Umfangslinie des außenliegenden Magnetpols die Projektion der äußeren Umfangslinie des innenliegenden Magnetpols einschließt und das Target durch mindestens einen, dem Verlauf der Umfangslinien geometrisch ähnlichen Luftspalt (14, 15) in mindestens zwei Targetteile (12, 12', 13, 16) unterteilt ist, die in Richtung auf die Basis des Jochs (9) gestaffelt auf der mindestens einen Auflagefläche (4a, 4c, 4d) angeordnet sind, wobei das Magnetsystem (6) in Blickrichtung auf die Basis des Jochs (9) hinter der am weitestens zurückgesetzten Auflagefläche (4a, 4c) für die Targetteile (12, 12', 13, 16) angeordnet ist, dadurch gekennzeichnet, daß die Breite (s) des mindestens einen Luftspalts (14, 15) in Richtung auf die Basis des Jochs (9) kleiner ist als der unter Betriebsbedingungen erforderliche Dunkelraumabstand.

2. Magnetronkatode nach Anspruch 1, dadurch gekennzeichnet, daß die Auflagefläche (4a, 4c, 4d) durch einen nicht ferromagnetischen, aber elektrisch leitfähigen Vorsprung (4b, 4e) stufenförmig unterteilt ist, daß die Targetteile (12, 13 bzw. 12, 12', 16) auf den einzelnen Stufen angeordnet sind und daß der Vorsprung (4b, 4e) nur soweit über die Zerstäubungsfläche (12a) des am weitesten hinten liegenden Katodenteils (12 bzw. 12/12') hervorsteht, daß die Breite des Luftspalts (14, 15) kleiner ist als der unter Betriebsbedingungen erforderliche Dunkelraumabstand.

3. Magnetronkatode nach den Ansprüchen 1 oder 2, dadurch gekennzeichnet, daß bei einem dreiteiligen Target
   a) eine Targetplatte durch einen umlaufenden Spalt (12c) in zwei zwischen gemeinsamen Ebenen liegende Targetteile (12, 12') unterteilt ist, wobei der Spaltverlauf dem Verlauf des Zwischenraumes zwischen den entgegengesetzten Polen (N, S) geometrisch ähnlich ist,

b) der Spalt (12c) durch den Vorsprung (4e) aus dem nicht-ferromagnetischen, aber elektrisch leitfähigem Werkstoff ausgefüllt ist, der über die Zerstäubungsflächen (12a) der Targetteile (12, 12') vorspringt,

c) ein drittes Targetteil (16) auf den Vorsprung (12a) aufgesetzt und ringförmig geschlossen ausgebildet ist und sein Verlauf dem Verlauf des Vorsprungs folgt und daß

d) das dritte Targetteil (10) beiderseits über den Vorsprung (4e) übersteht und gegenüber den Targetteilen (12, 12') je einen Luftspalt (14, 15) bildet (Figur 2).

4. Magnetronkatode nach einem der Ansprüche 1 bis 3, dadurch gekennzeichnet, daß das Maß « d » der Oberlappung mindestens einem Drittel der Targetdicke entspricht.

5. Magnetronkatode nach einem der Ansprüche 1 bis 4, dadurch gekennzeichnet, daß die Breite « s » des Luftspalts zwischen 0,5 und 2,5 mm beträgt.

## Claims

1. A magnetron cathode (1) for the sputtering of targets (12, 12') made from ferromagnetic materials, comprising a cathode main body having at least one supporting surface (4a, 4c, 4d) for the target, having a magnet system (6) with a yoke (9) and magnetic poles of opposite polarity disposed on said yoke and forming a respective pole unit along a closed circumferential line, wherein the projection into a common plane of the inner circumferential line of the external magnetic pole includes the projection of the outer circumferential line of the internal magnetic pole, and the target is subdivided into at least two target portions (12, 12', 13, 16) by at least one air gap (14, 15) geometrically similar to the shape of the circumferential line, which target portions are staggered towards the base of the yoke (9) and disposed on at least one supporting surface (4a, 4c, 4d), the magnet system (6) being disposed in the line of sight towards the base of the yoke (9) behind that supporting surface (4a, 4c) for the target portions (12, 12', 13, 16) which is set back to the furthest extent, characterised in that the width (s) of the at least one air gap (14, 15) in the direction towards the base of the yoke (9) is smaller than dark space distance required under operating conditions.

2. A magnetron cathode as claimed in claim 1, characterised in that the supporting surface (4a, 4c, 4d) is sub-divided in a stepped-shaped manner by a non-ferromagnetic but electrically conductive projection (4b, 4e), that the targets portions (12, 13 or 12, 12', 16) are disposed on the individual steps, and that the projection (4b, 4e) projects beyond the sputtering surface (12a) of the cathode portion (12 or 12/12') located furthest to the rear only to an extent that the width of the air gap (14, 15) is smaller than the dark space distance required operating conditions.

3. A magnetron cathode as claimed in claim 1 or 2, characterised in that, in the case of a tripartite target

a) a target plate is sub-divided by a continuous gap (12c) into two target portions (12, 12') lying between common planes, the shape of the gap being geometrically similar to the shape of the space between the opposite poles (N, S),

b) the gap (12c) is filled by the projection (4e) which is made from non-ferromagnetic but electrically conductive material and which projects beyond the sputtering surface (12a) of the target portions (12, 12'),

c) a third target portion (16) is mounted on the projection (12a) and is of annularly closed construction and its shape follows the shape of the projection, and that

d) the third target portion (10) projects beyond the projection (4e) at both sides and forms a respective air gap (14, 15) relative to each of the target portions (12, 12') (Figure 2).

4. A magnetron cathode as claimed in any one of claims 1 to 3, characterised in that the dimension « d » of the overlap corresponds to at least a third of the thickness of the target.

5. A magnetron cathode as claimed in any one of claims 1 to 4, characterised in that the width « s » of the air gap is from 0.5 to 2.5 mm.

## Revendications

1. Cathode-magnétron (1) pour la pulvérisation de cibles (12, 12') en matériaux ferromagnétiques, se composant d'un corps de cathode possédant au moins une surface d'appui (4a, 4c, 4d) pour la cible, un système magnétique (6) avec une culasse (9) et, sur celle-ci, des pôles magnétiques de polarité opposée, formant une unité polaire le long d'un périmètre continu, où la projection sur un plan commun du périmètre intérieur du pôle magnétique extérieur entoure la projection du périmètre extérieur du pôle magnétique intérieur et où la cible est subdivisée par au moins un entrefer (14, 15) dont la forme est géométriquement similaire à celle des périmètres en au moins deux parties de cible (12, 12', 13, 16) qui sont placées de manière décalée dans la direction de la base de la culasse (9) sur au moins une surface d'appui (4a, 4c, 4d), le système magnétique (6), lorsqu'on regarde dans la direction de la base de la culasse (9), se trouvant derrière la surface d'appui (4a, 4c) la plus reculée des parties de cible (12, 12', 13, 16), caractérisée en ce que la largeur (s) de l'entrefer (14, 15) minimal dans la direction de la base de la culasse (9) est inférieure à l'espace sombre nécessaire dans les conditions d'exploitation.

2. Cathode-magnétron selon la revendication 1, caractérisée en ce que la surface d'appui (4a, 4c, 4d) est subdivisée en gradins par une saillie (4b, 4e) non ferromagnétique mais électriquement conductrice, en ce que les parties de cible (12, 13 et 12, 12′ et 16) sont disposées sur les différents gradins et en ce que la saillie (4b, 4e) ne dépasse la surface de pulvérisation (12a) de la partie de cathode (12 ou 12/12′) la plus reculée que de la valeur nécessaire pour que la largeur de l'entrefer (14, 15) soit inférieure à l'espace sombre nécessaire dans les conditions d'exploitation.

3. Cathode-magnétron selon la revendication 1 ou 2, caractérisée, dans le cas d'une cible en trois parties,

a) en ce qu'une plaque de cible est divisée par une fente (12c) continue en deux parties de cible (12, 12′) situées entre des plans communs, la forme de la fente étant géométriquement similaire à celle de l'espace entre les pôles opposés (N, S),

b) en ce que la fente (12c) est remplie par la saillie (4e) en matériau non ferromagnétique mais électriquement conducteur qui dépasse les surfaces de pulvérisation (12a) des parties de cible (12, 12′),

c) en ce qu'une troisième partie de cible (16), de forme annulaire fermée, est placée sur la saillie (4e), sa forme suivant la forme de la saillie et

d) en ce que la troisième partie de cible (16) dépasse de part et d'autre de la saillie (4e) et forme un entrefer (14, 15) de chaque côté par rapport aux parties de la cible (12, 12′) (figure 2).

4. Cathode-magnétron selon l'une des revendications 1 à 3, caractérisée en ce que la cote « d » de recouvrement est au moins égale à un tiers de l'épaisseur de la cible.

5. Cathode-magnétron selon l'une des revendications 1 à 4, caractérisée en ce que la largeur « s » de l'entrefer est comprise entre 0,5 et 2,5 mm.

FIG.1

FIG.2

FIG. 3

FIG. 4

## FIG. 5

## FIG. 6

## FIG. 7